# EUROPÄISCHE PATENTSCHRIFT

(11) **EP 0 854 562 B1**
(45) Veröffentlichungstag und Bekanntmachung des Hinweises auf die Patenterteilung: **30.10.2002**
(21) Anmeldenummer: 97121973.8
(22) Anmeldetag: 12.12.1997
(51) Int. Cl.: H02M 3/155, H03K 17/0412

(54) **Schaltnetzteil**
Switching power supply
Alimentation de puissance à decoupape

(30) Priorität: 17.12.1996 DE 29621905 U
(43) Veröffentlichungstag der Anmeldung: 22.07.1998
(73) Patentinhaber: PAPST-MOTOREN GMBH & CO. KG, 78106 St. Georgen (DE)
(72) Erfinder: Doemen, Benno, Ing. (grad.), 78112 St. Georgen (DE)

(56) Entgegenhaltungen:
- EP-A- 0 677 861
- WO-A-95/06972
- DE-A- 3 403 282
- GB-A- 2 022 943
- US-A- 4 430 608
- US-A- 4 445 055
- US-A- 4 471 245
- US-A- 4 553 082
- PATENT ABSTRACTS OF JAPAN vol. 16, no. 415 (E-1257), 2.September 1992 & JP 04 140059 A (TOSHIBA), 14.Mai 1992,
- PATENT ABSTRACTS OF JAPAN vol. 16, no. 192 (E-1199), 11.Mai 1992 & JP 04 026360 A (MITSUBISHI), 29.Januar 1992,
- PATENT ABSTRACTS OF JAPAN vol. 16, no. 166 (E-1193), 22.April 1992 & JP 04 012664 A (MITSUBISHI), 17.Januar 1992,
- PATENT ABSTRACTS OF JAPAN vol. 96, no. 6, 28.Juni 1996 & JP 08 033324 A (TABUCHI DENKI), 2.Februar 1996,

## Beschreibung

Die vorliegende Erfindung betrifft ein Schaltnetzteil mit getaktetem Schaltregler, wobei ein elektronisches Schaltelement derart in einem bestimmten Tastverhältnis periodisch ein- und ausgeschaltet wird, daß aus einer gleichgerichteten Eingangsspannung über eine Speicherschaltung mit einer Speicherdrossel, einem Zwischenkreis-Speicherkondensator und einer Freilaufdiode eine Ausgangsregelspannung erzeugt wird.

Derartige Schaltnetzteile (Schaltregler) sind, wie beschrieben in Dokument, US 4430608, hinlänglich bekannt. Ihre Vorteile sind: relativ hoher Wirkungsgrad, relativ geringer Siebaufwand durch hohe Taktfrequenz, hoher Eingangsspannungsbereich; die Nachteile: Verwendung spezieller, zum Teil recht teurer Bauelemente (u.a. spezielle Speicherdrosseln mit Spezialferrit und gegebenenfalls mindestens zwei Wicklungen), Ansteuerschaltkreis erforderlich. Wegen der genannten Nachteile werden solche Schaltnetzteile - vor allem aus wirtschaftlichen Erwägungen - noch nicht für alle Einsätze verwendet, bei denen sie in technischer Hinsicht grundsätzlich gut geeignet wären.

Der vorliegenden Erfindung liegt daher die Aufgabe zugrunde, ein Schaltnetzteil der genannten Art zu schaffen, das durch eine deutliche Reduzierung der Kosten bei dennoch zumindest zufriedenstellendem Wirkungsgrad und hinreichend hoher Ausgangsleistung für ein größeres Anwendungsspektrum geeignet ist. Erfindungsgemäß wird dies dadurch erreicht, daß das Schaltelement von einem Transistor, und zwar einem Feldeffekttransistor (FET) oder einem IGBT (Insulated Gate Bipolar Transistor), gebildet ist, dessen Basis bzw. Gate eine spezielle Ansteuerschaltung derart vorgeschaltet ist, daß im Ansteuerstromkreis jeweils zum Durchschalten des Schaltelementes kurzzeitig ein erhöhter Ansteuerstrom und nachfolgend im durchgeschalteten Zustand ein deutlich geringerer Haltestrom fließt. Dabei ist zweckmäßigerweise dem Gate eine Vorwiderstandsbeschaltung vorgeschaltet, wobei durch die erfindungsgemäße Ansteuerschaltung dynamisch jeweils für die Zeit des Ansteuerns des Schaltelementes die Vorwiderstandsbeschaltung zumindest teilweise derart überbrückt (und dadurch niederohmiger gemacht) wird, daß für diese Zeit der relativ hohe Ansteuerstrom fließt, während nachfolgend nach dem Durchschalten des Schaltelements die Überbrückung der Vorwiderstandsbeschaltung aufgehoben wird, so daß der relativ geringere Haltstrom fließt.

Der Erfindung liegt die Erkenntnis zugrunde, daß das elektronische Schaltelement (FET/IGBT) zum Durchschalten eine relativ hohe Ansteuerenergie (Anlaufladung") benötigt, weil zwischen dem Hauptstrompfad (Drain/Source) und der Basis bzw. dem Gate sehr große innere Kapazitäten wirken, und das Schaltelement kann nur so schnell leitend werden (durchschalten), wie diese inneren Kapazitäten aufgeladen werden. Daher muß dafür gesorgt werden, daß im Ansteuerstromkreis innerhalb einer sehr kurzen Zeit (wenige µs) ein genügend hoher Strom fließen kann. Hierzu könnte grundsätzlich der Vorschaltwiderstand entsprechend niederohmig konzipiert werden (beispielsweise für einen Strom von mindestens 30 mA bei 230 V) , wodurch er aber für eine sehr hohe Verlustleistung auszulegen wäre (starke Erwärmung).

Durch die vorliegende Erfindung wird nun aber erreicht, daß die Vorwiderstandsbeschaltung insgesamt, d.h. in der Summe, relativ hochohmig sein kann, so daß im Normalfall, d.h. im durchgeschalteten Zustand des Schaltelements, auch der Strom - als Haltestrom - unbedeutend gering ist. Zum Durchschalten des Schaltelements wird dann aber über die erfindungsgemäße Ansteuerschaltung kurzzeitig ein hoher Ansteuerstrom praktisch als verstärkter Stromimpuls erzeugt, so daß es sich sozusagen um einen "Ansteuerpulsverstärker" handelt. Vorzugsweise wird hierzu ein Kondensator als Energiespeicher verwendet, der jeweils kurzzeitig (zumindest) einen Teil einer bevorzugt als Spannungsteiler ausgebildeten Vorwiderstandsbeschaltung im Gate-ansteuernden Strom- bzw. Wiederstandspfad überbrückt.

Durch die Erfindung ist vorteilhafterweise keine "aktive" Schaltung zur Erzeugung einer Hilfsspannung erforderlich. Vielmehr kommt die erfindungsgemäße Schaltung überwiegend mit passsiven und daher sehr preiswerten Bauteilen aus. Für die Widerstände der Vorwiderstandbeschaltung können wegen der sehr geringen Leistung billige Widerstandsklassen verwendet werden. Als (einziges) aktives Bauteil der erfindungsgemäßen Ansteuerschaltung kann ein sehr preisgünstiger Schalttransistor (z.B. BSR 19) verwendet werden.

Im Zusammenhang mit der Erfindung ist es ferner vorteilhaft, wenn das elektronische Schaltelement zusammen mit einem Kipptransistor (Strommeßtransistor) eine Kippschaltung bildet, wobei diese Kippschaltung über einen Steuerwiderstand stromgesteuert - und daher vorteilhafterweise kurzschlußfest - ist und über ein Steuersignal angesteuert wird. Für den Kipptransistor kann ein ebenfalls sehr preiswerter Kleinsignaltransistor (z.B. BC 847) verwendet werden. Bevorzugt wird dabei das Steuersignal von der Seite der Ausgangsregelspannung potentialfrei - insbesondere über einen Optokoppler - in den Regelkreis des Schaltreglers zurückgekoppelt. Hierdurch wird eine zweite, sehr teure Wicklung auf der Speicherdrossel eingespart, so daß eine sehr preiswerte Speicherdrossel mit nur einer Wicklung und daher auch sehr geringem Isolationsaufwand eingesetzt werden kann (Stab- oder Ringdrossel).

Weitere vorteilhafte Ausgestaltungsmerkmale der Erfindung sind in den Unteransprüchen sowie der folgenden Beschreibung enthalten.

Anhand der Zeichnung soll nun die Erfindung beispielhaft genauer erläutert werden. Dabei zeigen:
- Fig. 1: ein Schaltbild eines Schaltnetzteils zur Erläuterung der grundsätzlichen Funktionsweise,
- Fig. 2: ein Schaltbild eines erfindungsgemäßen Schaltnetzteils einer ersten Ausführungsform der speziellen Ansteuerschaltung,
- Fig. 3: einen detaillierteren Stromlaufplan des erfindungsgemäßen Schaltnetzteils mit vorteilhaften Ausgestaltungsmerkmalen und
- Fig. 4 bis 7: weitere Ausführungsvarianten der erfindungsgemäßen Ansteuerschaltung.

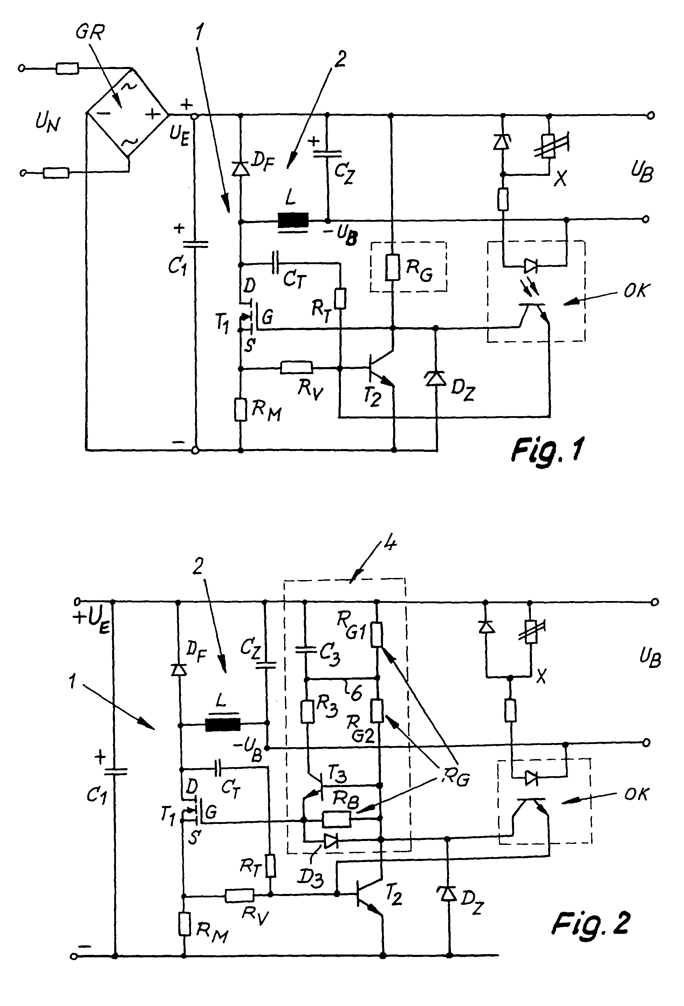

Gemäß Fig. 1 wird eine eingangsseitige Wechselspannung, üblicherweise eine Netzspannung U_{N}, über einen Gleichrichter GR gleichgerichtet und vorzugsweise durch einen Parallelkondensator C₁ geglättet; es entsteht eine gleichgerichtete Eingangsspannung U_{E}, aus der mittels eines getakteten Schaltreglers 1 eine Ausgangsregelspannung U_{B} erzeugt wird.

Dies geschieht - in an sich bekannter Weise - dadurch, daß ein elektronisches Schaltelement T₁ in einem bestimmten, der gewünschten Regelspannung entsprechenden Taktverhältnis periodisch ein- und ausgeschaltet wird. Das Schaltelement T₁ wirkt hierzu mit einer Speicherschaltung 2 zusammen, die aus einer Speicherdrossel L, einem Zwischenkreis-Speicherkondensator C_{Z} und einer Freilaufdiode D_{F} besteht. Dies ist grundsätzlich Stand der Technik und bedarf daher keiner näheren Erläuterung.

Das Schaltelement T₁ ist in der dargestellten Ausführung ein FET, dessen Source-Anschluß S über einen Steuerwiderstand R_{M} mit der Minusleitung "-" und dessen Drain-Anschluß D mit der Speicherdrossel L sowie über die Freilaufdiode D_{F} mit der Plusleitung "+" verbunden ist. Der andere Anschluß der Speicherdrossel L bildet die Minusleitung -U_{B} der Ausgangsregelspannung U_{B}. Der Speicherkondensator C_{Z} liegt zwischen der Plusleitung und -U_{B}.

In der Darstellung nach Fig. 1 ist dem Gate-Anschluß G des Schaltelements T₁ eine aus nur einem Einzelwiderstand bestehende Vorwiderstandsbeschaltung R_{G} vorgeschaltet. Wie eingangs schon erläutert wurde, müßte dieser Einzelwiderstand sehr niederohmig und daher für hohe Leistung ausgelegt werden.

Gemäß Fig. 2 ist daher erfindungsgemäß an dieser Stelle eine spezielle Ansteuerschaltung 4 vorgesehen, die mit einer gestrichelten Linie umrahmt und so hervorgehoben ist. Dabei ist die Vorwiderstandsbeschaltung R_{G} als Spannungsteiler aus mindestens zwei, gemäß Fig. 2 aus drei Einzelwiderständen R_{G1}, R_{G2} und R_{B} gebildet. Parallel zu dem letztgenannten Einzelwiderstand R_{B} liegt die Basis-Emitter-Strecke eines Ansteuertransistors T₃, wobei der Widerstand R_{B} derart ausgelegt ist, daß bei einem Stromfluß über die gesamte Vorwiderstandsbeschaltung an R_{B} jedenfalls eine Spannung mit einer Höhe abfällt (z.B. im Bereich von 0,7 bis 2 V) , daß dadurch der Ansteuertransistor T₃ durchschalten kann. Der Ansteuertransistor T₃ liegt mit seinem Hauptstrompfad, seiner Kollektor-Emitter-Strecke, in einem Nebenzweig parallel zur Vorwiderstandsbeschaltung R_{G}. In diesem Nebenzweig sind in Reihe zwischen Kollektor und Plusleitung ein Schutzwiderstand R₃ und - als Energiespeicher - ein Kondensator C₃ angeordnet. Vorzugsweise ist der Punkt zwischen den Einzelwiderständen R_{G1} und R_{G2} der Vorwiderstandsbeschaltung mit dem Punkt zwischen dem Kondensator C₃ und dem Schutzwiderstand R₃ über eine Querverbindung 6 verbunden. Zudem liegt parallel zu der Basis-Emitter-Strecke des Ansteuertransistors T₃ und zu dem dazu parallelen Einzelwiderstand R_{B} eine Entladediode D₃. Die Funktion dieser erfindungsgemäßen Ansteuerschaltung wird weiter unten noch genauer erläutert werden.

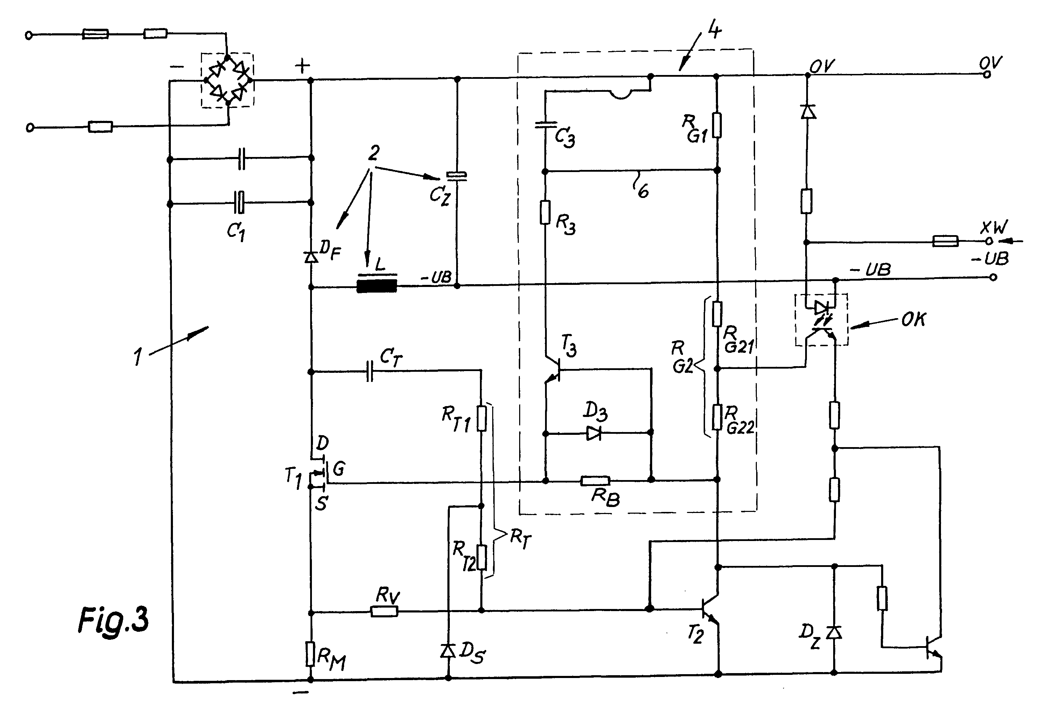

Wie sich aus allen Zeichnungsfiguren ergibt, bildet das elektronische Schaltelement T₁ zusammen mit einem zweiten Transistor T₂, hier Kipptransistor genannt, eine Kippschaltung, die über den Steuerwiderstand R_{M} stromgesteuert - und daher vorteilhafterweise kurzschlußfest - ist. Hierbei wird die Kippschaltung T₁/T₂ über ein Steuer- bzw. Regelsignal X angesteuert. Dieses Steuersignal X wird vorteilhafterweise von der Seite der Ausgangsregelspannung U_{B} potentialfrei - insbesondere über einen Optokoppler OK - in den Regelkreis des Schaltreglers zurückgekoppelt. Hierzu ist der Optokoppler OK primärseitig einerseits mit -U_{B} verbunden und andererseits über einen Widerstand und eine Zenerdiode mit der Plusleitung. Hier wird das Steuersignal X abgeleitet; in Fig. 1 und 2 wird dies vereinfacht durch ein eingezeichnetes Potentiometer veranschaulicht. Sekundärseitig ist der Optokoppler OK einerseits mit der Basis des Kipptransistors T₂ und andererseits vorzugsweise mit einem Spannungsteilerabgriff zwischen zwei Einzelwiderständen (gemäß Fig.1 und 2 R_{G2} und R_{B} bzw. gemäß Fig. 3 R_{G21} und R_{G22}) der Vorwiderstandsbeschaltung R_{G} verbunden. Die Basis des Kipptransistors T₂ ist zudem einerseits über ein Reihen-R/C-Glied aus einem Widerstand R_{T} und einem Kondensator C_{T} mit dem Drain-Anschluß D des Schaltelements T₁ und andererseits - insbesondere über einen Vorwiderstand R_{V} - mit einem Schaltpunkt zwischen dem Steuerwiderstand R_{M} und dem Source-Anschluß S des Schaltelements T₁ verbunden. Mit seiner Kollektor-Emitter-Strecke liegt der Kipptransistor T₂ zwischen dem Gate-Anschluß G des Schaltelements T₁, und zwar vorzugsweise einem Spannungsteilerabgriff zwischen zwei Einzelwiderständen R_{B} und R_{G2} bzw. R_{G22}, einerseits und der Minusleitung andererseits. Zudem liegt parallel zur Kollektor-Emitter-Strecke des Kipptransistors eine Zenerdiode D_{Z}.

Im folgenden soll anhand der Fig. 2 die Funktionsweise genauer erläutert werden. Die Vorwiderstandbeschaltung R_{G} ist in der Summe der Einzelwiderstände relativ hochohmig konzipiert, so daß über diesen Zweig nur noch ein sehr geringer Strom fließen kann. Wenn nun in einem bestimmten Zeitpunkt die Ausgangsregelspannung U_{B} unter den Sollwert sinkt, wird über das entsprechende Regelsignal X der Kipptransistor T₂ gesperrt, um hierdurch das Schaltelement T₁ leitend zu machen. Hierdurch fließt dann über die Vorwiderstandsbeschaltung R_{G} ein sehr geringer Strom von beispielsweise nur 1 bis 1,5 mA, was verlustleistungsmäßig auch ohne spezielle Maßnahmen völlig problemlos ist. Dabei wird dann aber der Ansteuertransistor T₃ relativ schnell leitend, bedingt durch den Spannungsabfall an R_{B}. Wenn T₃ leitend wird, fließt über dessen Kollektor-Emitter-Strecke parallel zu dem R_{G}-Zweig über C₃ und R₃ (der mit beispielsweise 1,5 kΩ vernachlässigbar klein ist und nur zum Kurzschluß-Schutz von T₃ dient) ein relativ großer Strom ins Gate G von T₁. Es steht somit ein hoher Gate-Ansteuerleistungsimpuls zur Verfügung ("Pulsverstärker"). Hierdurch werden die Kapazitäten des Schaltelements T₁ sehr schnell aufgeladen, so daß T₁ sehr zügig durchschaltet. Dann hört dieser Ladestromfluß auf und der Ansteuertransistor T₃ sperrt nach einer e-Funktion. Der durchgeschaltete Zustand von T₁ wird im weiteren Verlauf über die Reihenschaltung R_{G} gehalten, wozu nur noch ein äußerst geringer Strom von einigen µA fließen, die verlustleistungsmäßig völlig unbeachtlich sind. Nach einer bestimmten Durchschaltzeit von T₁ erfolgt dann in Abhängigkeit vom Steuersignal X das Abschalten über Durchschalten des Kipptransistors T₂. Dabei wird das Gate G des Schaltelements T₁ über die Entladediode D₃ entladen.

Mit vereinfachten und kurzen Worten stellt sich somit die grundsätzliche Funktion wie folgt dar:

Wenn die Spannung U_{B} unter den Sollwert sinkt und T₂ sperrt, damit T₁ leitend wird, fließt ein Strom über R_{G} (R_{G1}, R_{G2} und R_{B}) in Gate G. Damit wird T₃ leitend und zieht über R₃ aus C₃ (und R_{G1}) einen relativ großen Strom zum Laden der Gatekapazitäten (Q_{G} ca. 20 nC), und T₁ kann wie gewünscht mit steiler Flanke durchschalten. Wenn die Gatekapazitäten geladen sind, wird der Strom über R_{B} so klein, daß T₃ sperrt. C₃ hat genügend Zeit, sich über R_{G1} auf das Spannungsteilerverhältnis R_{G1}/R_{G2} zu entladen. Wenn der Strom über R_{M} den Kipptransistor T₂ in den leitenden Zustand führt, kann das Gate über D₃ schnell entladen werden. Unterstützt wird das Umschalten stets durch das R_{T}/C_{T}-Glied.

Anhand der Fig. 3 sollen nun noch vorteilhafte Ausgestaltungsmerkmale erläutert werden.

Das Steuer- oder Stellsignal X kommt hierbei von einem nicht dargestellten Verbraucher, weshalb es in Fig. 3 mit XW bezeichnet ist. Diese Ausführung eignet sich insbesondere zur Speisung von Elektromotoren, z.B. Lüftermotoren mit vermaschtem Regelkreis. Hierbei steuert der Regelkreis bzw. Drehzahlregler des Motors den Vorregelkreis des Schaltnetzteils so an, daß der Motor stets eine geringfügig höhere Spannung erhält, als er wirklich braucht. Hierdurch ist sichergestellt, daß die eigentliche Motor-Drehzahlregelung stets eine hinreichend große Spannung zur Verfügung hat.

Ferner ist gemäß Fig. 3 der Einzelwiderstand R_{G2} nochmals in zwei Widerstände R_{G21} und R_{G22} aufgeteilt. Der Schaltpunkt zwischen diesen beiden Widerständen dient zum Anschluß des Sekundärkreises des Optokopplers OK.

Schließlich soll noch eine besondere Schaltungsmaßnahme genauer erläutert werden. Hierzu zunächst folgender Hintergrund: Wenn das Schaltelement T₁ in den sperrenden Zustand geht, wird C_{T} auf volle Spannung aufgeladen, wobei die Widerstände den Strom begrenzen. Wenn T₁ leitend wird, würde er die Spannung von C_{T} umkehren, so daß an der Basis von T₂ beispielsweise -200V anliegen würden. Dies würde zur Zerstörung von T₂ führen.Um dies zu vermeiden,ist zweckmäßigerweise vorgesehen, den Widerstand R_{T} als Spannungsteiler aus zwei Teilwiderständen R_{T1} und R_{T2} zu bilden, und zwar in einer sehr unsymmetrischen Aufteilung von etwa 1 : 10. Im Spannungsteilerabgriff ist eine Schutzdiode D_{S} angeschlossen, deren andere Seite mit der Minusleitung verbunden ist. Wenn nun T₁ sperrt, ist die Schutzdiode D_{S} im Grunde wirkungslos; es wirkt das "normale" R_{T}/C_{T}-Glied, um das Leitendwerden des Kipptransistors T₂ sicherzustellen. Wenn das Schaltelement T₁ wieder leitend wird, zieht es Strom über die Schutzdiode D_{S} und den kleineren Teilwiderstand R_{T1} und lädt dabei den Kondensator C_{T} um. Dadurch liegt an der Basis von T₂ über den etwa zehnmal höheren Teilwiderstand R_{T2} eine negative Spannung von nur beispielsweise 0,7 bis 1,1V. Dies ist bei dem hohen Vorwiderstand unbedeutend; im Gegenteil ist dies sogar vorteilhaft, weil hierdurch T₂ ganz sicher sperrt. Diese Maßnahme führt zudem zu dem zweiten Vorteil, daß in dem Zeitkreis ungleiche Zeitkonstanten zur Wirkung kommen. Während der relativ kurzen Leitungsphasen von T₁ muß jeweils C_{T} umgeladen bzw. entladen werden, was über die Diode D_{S} und nur über den kleineren Widerstand R_{T1} erfolgt. Zum Laden wirken aber beide Teilwiderstände R_{T1} + R_{T2} beim Leitendhalten von T₂.

Abschließend sollen noch einige Größenwerte für die Bauteile der erfindungsgemäßen Schaltung beispielhaft angegeben werden.
R_{G1} = 82 KΩ, R_{G2} = 44 kΩ (2 x 22 kΩ), R_{B} = 22 kΩ, R₃ = 1,5 kΩ, C₃ = 220 pF, D₃ = z.B. BAS 216, R_{T1} = 15 kΩ, R_{T2} = 160 kΩ, C_{T} = 220 pF.

Die Erfindung führt in erster Linie zu dem Vorteil einer gravierenden Kostenreduzierung. Das erfindungsgemäße Netzteil kann deutlich billiger als herkömmliche Schaltnetzteile einer vergleichbaren Leistung angeboten werden, so daß es sich für viele Anwendungsfälle anbietet. Trotz der äußerst niedrigen Kosten eignet sich der erfindungsgemäße Schaltregler für einen weiten Eingangsspannungsbereich (U_{N} = 90 bis 264 V AC) und einen weiten steuerbaren Niederspannungs-Ausgangsbereich (UB = 120 bis 375 V DC), wobei auch nur eine geringe Verlustleistung zu verzeichnen ist.

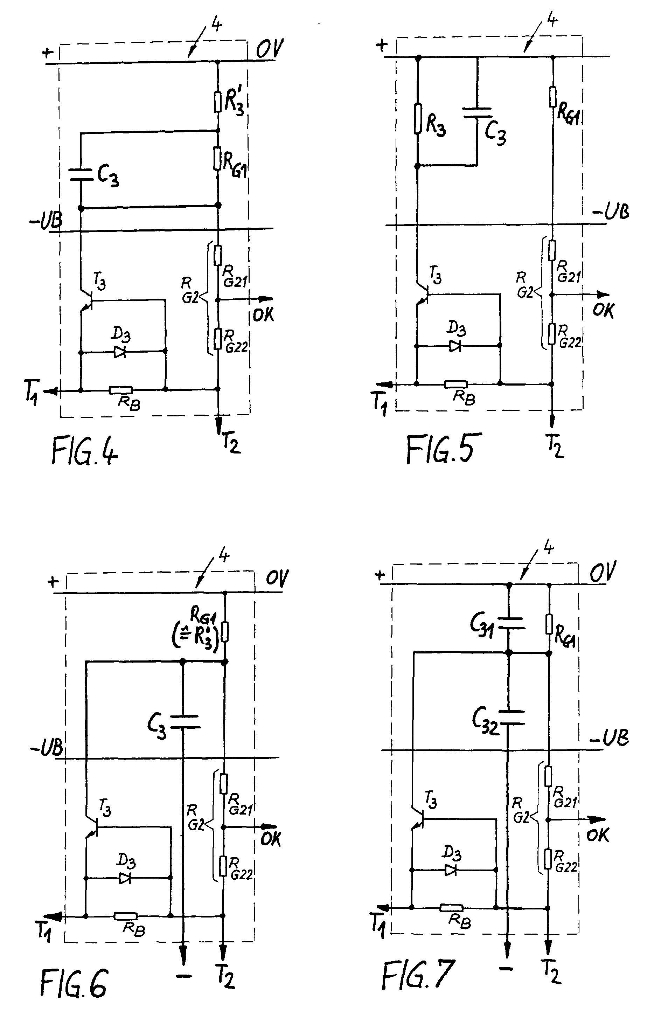

In den Fig. 4 bis 7 sind noch einige Ausführungsvarianten der erfindungsgemäßen Ansteuerschaltung 4 veranschaulicht. Allen Ausführungsvarianten ist gemeinsam, daß (mindestens) ein Kondensator als Energiespeicher parallel zu einem Entladewiderstand angeordnet ist und somit diesen Entladewiderstand zeitweise überbrückt.

Im Falle der Fig. 4 liegt der Kondensator C₃ parallel zu dem Widerstand R_{G1} und in Reihe zum Kollektor des Ansteuertransistors T₃. Zudem ist hier ein Schutzwiderstand R'₃ zwischen dem Kondensator C₃ und der Plusleitung vorgesehen, wodurch der Transistor C₃ nur für eine relativ geringe Spannung ausgelegt zu sein braucht.

Gemäß Fig. 5 ist dem Kollektor des Transistors T₃ eine Parallelschaltung aus dem Widerstand R₃ und dem Kondensator C₃ vorgeschaltet. Hierbei müßte allerdings der Transistor T₃ für die volle Kollektor-/Emitterspannung ausgelegt sein.

Bei den Ausführungen nach Fig. 6 und 7 ist jeweils der Energiespeicher-Kondensator parallel zu einem Teil des Spannungsteilers angeordnet. Gemäß Fig. 6 liegt der Kondensator C₃ parallel zum Widerstand R_{G2} zwischen dem Mittenabgriff des Spannungsteilers und der Minusleitung.

Gemäß Fig. 7 ist der Energiespeicher-Kondensator in zwei Teilkapazitäten C₃₁ und C₃₂ aufgeteilt, die einen kapazitiven Spannungsteiler bilden, der zu dem ohmschen Spannungsteiler parallel geschaltet ist.

Es sei noch erwähnt, daß gemäß Fig. 6 der Widerstand R_{G1} des Spannungsteilers gleichzeitig auch als Schutzwiderstand R'₃ für den Transistor C₃ wirkt. Im Falle der Fig. 7 muß - analog zu Fig. 5 - der Transistor C₃ wiederum für die volle C/E-Spannung ausgelegt sein.

Die Erfindung ist nicht auf die konkret beschriebenen Ausführungsbeispiele beschränkt, sondern umfaßt auch alle im Sinne der Erfindung gleichwirkenden Ausführungen. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmalen definiert sein. Dies bedeutet, daß grundsätzlich praktisch jedes Einzelmerkmal des Anspruchs 1 weggelassen bzw. durch mindestens ein an anderer Stelle der Anmeldung offenbartes Einzelmerkmal ersetzt werden kann. Insofern ist der Anspruch 1 lediglich als ein erster Formulierungsversuch für eine Erfindung zu verstehen.

## Patentansprüche

1. Schaltnetzteil mit getaktetem Schaltregler (1), wobei ein elektronisches Schaltelement (T₁) derart in einem bestimmten Tastverhältnis periodisch ein- und ausgeschaltet wird, daß aus einer gleichgerichteten Eingangsspannung (U_{E}) über eine Speicherschaltung (2) mit einer Speicherdrossel (L), einem Zwischenkreis-Speicherkondensator (C₂) und einer Freilaufdiode (D_{F}) eine Ausgangsregelspannung (U_{B}) erzeugt wird,
**dadurch gekennzeichnet, daß** das Schaltelement (T₁) von einem FET oder IGBT gebildet ist, dessen Gate (G) eine Ansteuerschaltung (4) als Pulsverstärker derart vorgeschaltet ist, daß jeweils zum Durchschalten im Gate-Ansteuerkreis zum schnellen Laden von inneren Kapazitäten des Schaltelementes (T₁) kurzzeitig ein verstärkter Stromimpuls erzeugt wird und nachfolgend im durchgeschalteten Zustand aufgrund der geladenen inneren Kapazitäten nur noch ein deutlich geringerer Reststrom fließt, wobei dem Gate (G) des Schaltelementes (T₁) eine Vorwiderstandsbeschaltung (R_{G}) vorgeschaltet ist und durch die Ansteuerschaltung (4) dynamisch jeweils für die Zeit des Ansteuerns des Schaltelementes (T₁) die Vorwiderstandsbeschaltung (R_{G}) zumindest teilweise derart überbrückt wird, daß für diese Zeit der relativ hohe Ansteuerstrom fließt, während nachfolgend nach dem Durchschalten des Schaltelementes (T₁) die Überbrückung der Vorwiderstandsbeschaltung (R_{G}) aufgehoben wird, so daß der relativ geringere Reststrom fließt, wobei die Vorwiderstandsbeschaltung (R_{G}) als Spannungsteiler aus mindestens zwei Einzelwiderständen (R_{G1},R_{G2};R_{B}) gebildet ist, von denen mindestens einer (R_{B}) parallel zur Basis-Emitter-Strecke eines Ansteuertransistors (T₃) liegt, wobei der Ansteuertransistor (T₃) mit seiner Kollektor-Emitter-Strecke in einem Nebenzweig parallel zu wenigstens einem Teil der Vorwiderstandsbeschaltung (R_{G}) liegt.

2. Schaltnetzteil nach Anspruch 1,
**dadurch gekennzeichnet, daß** die Ansteuerschaltung (4) zum Durchschalten dynamisch in Abhängigkeit von dem jeweiligen Gate-Strom kurzzeitig aus einem Energiespeicher (C₃) den Ansteuerstrom pulsartig verstärkt.

3. Schaltnetzteil nach Anspruch 2,
**dadurch gekennzeichnet, daß** der Energiespeicher mindestens ein Kondensator (C₃/C₃₁, C₃₂) mit mindestens einem parallel geschalteten Entladewiderstand (R_{G1}; R₃; R_{G21}; R_{G22}) ist.

4. Schaltnetzteil nach Anspruch 2 oder 3,
**dadurch gekennzeichnet, da**ß der Energiespeicher (C₃) parallel zu einem Teil der als Spannungsteiler aus vorzugsweise mindestens drei Einzelwiderständen (R_{G1}; R_{G2}; R_{B}) gebildeten Vorwiderstandsbeschaltung liegt.

5. Schaltnetzteil nach einem der Ansprüche 2 bis 4,
**dadurch gekennzeichnet, daß** in dem Nebenzweig in Reihe ein Kondensator (C₃) und ein Schutzwiderstand (R₃) angeordnet sind, wobei vorzugsweise der Punkt zwischen zwei Einzelwiderständen (R_{G1}; R_{G2}) der Vorwiderstandsbeschaltung (R_{G}) mit dem Punkt zwischen dem Kondensator (C₃) und dem Schutzwiderstand (R₃) über eine Querverbindung (6) verbunden ist.

6. Schaltnetzteil nach einem der Ansprüche 1 bis 5,
**dadurch gekennzeichnet, daß** parallel zu der Basis-Emitter-Strecke des Ansteuertransistors (T₃) und zu dem dazu parallelen Einzelwiderstand (R_{B}) eine Entladediode (D₃) zum Entladen des Gate (G) des Schaltelementes (T₁) geschaltet ist.

7. Schaltnetzteil nach einem der Ansprüche 1 bis 6,
**dadurch gekennzeichnet, daß** das elektronische Schaltelement (T₁) zusammen mit einem Kipptransistor (T₂) eine Kippschaltung bildet, wobei diese Kippschaltung (T₁/T₂) über einen Steuerwiderstand (R_{M}) stromgesteuert ist und über ein Steuersignal (X/XW) angesteuert wird.

8. Schaltnetzteil nach Anspruch 7,
**dadurch gekennzeichnet, daß** das Steuersignal (X/XW) von der Seite der Ausgangsregelspannung (U_{B}) potentialfrei - insbesondere über einen Optokoppler (OK) - in den Regelkreis des Schaltreglers (1) zurückgekoppelt wird.

9. Schaltnetzteil nach Anspruch 8,
**dadurch gekennzeichnet, daß** der Optokoppler (OK) sekundärseitig einerseits mit der Basis des Kipptransistors (T₂) und andererseits vorzugsweise mit einem Spannungsteilerabgriff zwischen zwei Einzelwiderständen (R_{G2}, R_{B} bzw. R_{G21}, R_{G22}) der Vorwiderstandsbeschaltung (R_{G}) verbunden ist.

10. Schaltnetzteil nach einem der Ansprüche 7 bis 9,
**dadurch gekennzeichnet, daß** die Basis des Kipptransistors (T₂) einerseits über ein Reihen-R/C-Glied (R_{T}, C_{T}) mit dem Drain-Anschluß (D) des Schaltelementes (T₁) und andererseits - insbesondere über einen Vorwiderstand (R_{V})- mit einem Schaltpunkt zwischen dem Steuerwiderstand (R_{M}) und dem Source-Anschluß (S) des Schaltelemenetes (T₁) verbunden ist.

11. Schaltnetzteil nach einem der Ansprüche 7 bis 10,
**dadurch gekennzeichnet, daß** der Kipptransistor (T₂) mit seiner Kollektor-Emitter-Strecke zwischen einerseits dem Gate-Anschluß (G) des Schaltelementes (T₁), insbesondere einem Spannungsteilerabgriff zwischen zwei Einzelwiderständen (R_{B} und R_{G2} bzw. R_{G22}) und andererseits einer Minusleitung (-) liegt.

12. Schaltnetzteil nach einem der Ansprüche 7 bis 11,
**dadurch gekennzeichnet, daß** parallel zur Kollektor-Emitter-Strecke des Kipptransistors (T₂) einer Zenerdiode (D₂) liegt.

13. Schaltnetzteil nach einem der Ansprüche 10 bis 12,
**dadurch gekennzeichnet, daß** das Reihen-RC-Glied(R_{T}; C_{T}) einen als Spannungsteiler aus zwei Teilwiderständen (R_{T1',} R_{T2}) gebildeten Widerstand aufweist, wobei deren Mittenabgriff über eine Schutzdiode (D_{S}) mit der Minusleitung (-) verbunden ist.

## Claims

1. Switching power supply with a pulsed switching controller (1), wherein an electronic switching element (T₁) is switched on and off periodically with a specific pulse duty cycle such that an output control voltage (U_{B}) is produced from a rectified input voltage (U_{E}) through a storage circuit (2) with a storage choke (L), an intermediate circuit storage capacitor (C₂) and a free running diode (D_{F}), **characterised in that** the switching element (T₁) is formed by an FET or IGBT whose gate (G) is connected in series with an actuating circuit (4) as pulse amplifier such that an amplified current pulse is briefly produced in each case to switch in the gate actuating circuit to rapid charging of internal capacitances of the switching element (T₁) and thereafter only a significantly lower residual current flows in the switched state due to the charged internal capacitances, the gate (G) of the switching element (T₁) being connected in series with a dropping resistor circuit (R_{G}) and the dropping resistor circuit (R_{G}) being at least partly bridged dynamically by the actuating circuit (4) in each case for the time of actuation of the switching element (T₁) such that the relatively high actuating current flows for this time whereas thereafter after the switching of the switching element (T₁) the bridging of the dropping resistor circuit (R_{G}) is terminated so that the relatively lower residual current flows, the dropping resistor circuit (R_{G}) being formed as a voltage divider from at least two individual resistors (R_{G1}, R_{G2}; R_{B}), at least one of which (R_{B}) lies parallel with the base-emitter junction of an actuating transistor (T₃), the actuating transistor (T₃) lying with its collector-emitter junction in an auxiliary branch parallel to at least one part of the dropping resistor circuit (R_{G}).

2. Switching power supply according to claim 1, **characterised in that** the actuating circuit (4) for switching dynamically amplifies the actuating current in pulses according to the respective gate current briefly from an energy store (C₃).

3. Switching power supply according to claim 2, **characterised in that** the energy store is at least one capacitor (C₃/C₃₁, C₃₂) with at least one discharge resistor (R_{G1}; R₃; R_{G21}; R_{G22}) connected in parallel.

4. Switching power supply according to claim 2 or 3, **characterised in that** the energy store (C₃) lies parallel to a part of the dropping resistor circuit formed as a voltage divider from preferably at least three individual resistors (R_{G1}; R_{G2}; R_{B}).

5. Switching power supply according to one of claims 2 to 4, **characterised in that** a capacitor (C₃) and a protective resistor (R₃) are arranged in series in the auxiliary branch, the point between two individual resistors (R_{G1}; R_{G2}) of the dropping resistor circuit (R_{G}) preferably being connected to the point between the capacitor (C₃) and the protective resistor (R₃) by means of a transverse connection (6).

6. Switching power supply according to one of claims 1 to 5, **characterised in that** a discharge diode (D₃) for discharging the gate (G) of the switching element (T₁) is connected parallel to the base-emitter junction of the actuating transistor (T₃) and the individual resistor (R_{B}) parallel to it.

7. Switching power supply according to one of claims 1 to 6, **characterised in that** the electronic switching element (T₁) together with a tripping transistor (T₂) forms a tripping circuit, this tripping circuit (T₁/T₂) being controlled by current through a control resistor (R_{M}) and actuated by means of a control signal (X/XW).

8. Switching power supply according to claim 7, **characterised in that** the control signal (X/XW) from the side of the output control voltage (U_{B}) is fed back potential free into the loop of the switching controller (1) - in particular through an optocoupler (OK).

9. Switching power supply according to claim 8, **characterised in that** the optocoupler (OK) is connected on the secondary side firstly with the base of the tripping transistor (T₂) and secondly preferably with a voltage divider tap between two individual resistors (R_{G2}, R_{B} or R_{G21}, R_{G22}) of the dropping resistor circuit (R_{G}).

10. Switching power supply according to one of claims 7 to 9, **characterised in that** the base of the tripping transistor (T₂) is connected firstly through a series R/C member (R_{T}, C_{T}) to the drain connection (D) of the switching element (T₁) and secondly - in particular through a dropping resistor (R_{V}) - to a switching point between the control resistor (R_{M}) and the source connection (S) of the switching element (T₁).

11. Switching power supply according to one of claims 7 to 10, **characterised in that** the tripping transistor (T₂) lies with its collector-emitter junction between firstly the gate connection (G) of the switching element (T₁), in particular a voltage divider tap between two individual resistors (R_{B} and R_{G2} or R_{G22}), and secondly a negative lead (-).

12. Switching power supply according to one of claims 7 to 11, **characterised in that** a zener diode (D₂) lies parallel to the collector-emitter junction of the tripping transistor (T₂).

13. Switching power supply according to one of claims 10 to 12, **characterised in that** the series RC member (R_{T}; C_{T}) exhibits a resistor formed as a voltage divider from two part resistors (R_{T1}, R_{T2}), its centre tap being connected through a protective diode (D_{S}) to the negative lead (-).

## Revendications

1. Alimentation à découpage avec régulateur de commande cadencé (1) dans lequel un élément de commutation électronique (T₁) est rendu périodiquement passant et bloqué selon un rapport cyclique défini de manière à générer une tension régulée de sortie (U_{B}) à partir d'une tension d'entrée continue (U_{E}) par l'intermédiaire d'un circuit de stockage (2) comportant une bobine de stockage (L), un condensateur de stockage intermédiaire (C₂) et une diode de roue libre (D_{F}),
**caractérisée par le fait que** l'élément de commutation (T₁) est constitué par un FET ou un IGBT dont la grille (G) est placée en amont d'un circuit de commande (4) formant amplificateur d'impulsions de telle façon qu'à chaque commutation dans le circuit de commande de la grille pour la charge rapide des capacités internes de l'élément de commutation (T₁) il est généré brièvement une impulsion de courant amplifiée et qu'ensuite, à l'état commuté, il ne circule plus qu'un courant résiduel nettement plus faible en raison des capacités internes chargées, un circuit résistant série (R_{G}) étant placé en amont de la grille (G) de l'élément de commutation (T₁) et le circuit résistant série (R_{G}) étant shunté au moins partiellement par le circuit de commande (4), dynamiquement pendant le temps de la commande de l'élément de commutation (T₁), de telle façon que pendant ce temps le courant de commande relativement élevé circule, tandis qu'après la commutation de l'élément de commutation (T₁) le shuntage du circuit résistant série (R_{G}) est levé de telle manière que le courant résiduel relativement faible circule, le circuit résistant série (R_{G}) ayant la forme d'un diviseur de tension composé d'au moins deux résistances individuelles (R_{G1}, R_{G2} ; R_{B}) dont au moins une (R_{B}) est branchée en parallèle avec la ligne base-émetteur d'un transistor de commande (T₃), le transistor de commande (T₃) étant en parallèle par sa ligne collecteur-émetteur avec au moins une partie du circuit résistant série (R_{G}) dans une branche secondaire.

2. Alimentation à découpage selon la revendication 1,
**caractérisée par le fait que** le circuit de commande (4) pour la commutation, dynamiquement en fonction du courant de grille, amplifie brièvement le courant de commande par impulsions à partir d'un accumulateur d'énergie (C₃).

3. Alimentation à découpage selon la revendication 2,
**caractérisée par le fait que** l'accumulateur d'énergie est au moins un condensateur (C₃/C₃₁, C₃₂) avec au moins une résistance de décharge (R_{G1} ; R₃ ; R_{G21} ; R_{G22}) branchée en parallèle.

4. Alimentation à découpage selon la revendication 2 ou 3,
**caractérisée par le fait que** l'accumulateur d'énergie (C₃) est branché en parallèle avec une partie du circuit résistant série formé comme un diviseur de tension composé de préférence d'au moins trois résistances individuelles (R_{G1} ; R_{G2}; R_{B}).

5. Alimentation à découpage selon l'une des revendications 2 à 4,
**caractérisée par le fait qu'**un condensateur (C₃) et une résistance de protection (R₃) sont placés en série dans la branche secondaire, dans laquelle de préférence le point entre deux résistances individuelles (R_{G1} ; R_{G2}) du circuit résistant série (R_{G}) est relié au point entre le condensateur (C₃) et la résistance de protection (R₃) par une liaison transversale (6).

6. Alimentation à découpage selon l'une des revendications 1 à 5,
**caractérisée par le fait qu'**une diode de décharge (D₃) pour la décharge de la grille (G) de l'élément de commutation (T₁) est branchée en parallèle avec la ligne base-émetteur du transistor de commande (T₃) et avec la résistance individuelle (R_{B}) parallèle à celle-ci.

7. Alimentation à découpage selon l'une des revendications 1 à 6,
**caractérisée par le fait que** l'élément de commutation électronique (T₁) forme avec un transistor à bascule (T₂) une bascule, cette bascule (T₁/T₂) étant commandée en courant via une résistance de commande (R_{M}) et activée par un signal de commande (X/XW).

8. Alimentation à découpage selon la revendication 7,
**caractérisée par le fait que** le signal de commande (X/XW) est ramené sans potentiel - en particulier via un optocoupleur (OK) - du côté de la tension régulée de sortie (U_{B}) dans le circuit de régulation du régulateur de commande (1).

9. Alimentation à découpage selon la revendication 8,
**caractérisée par le fait que** l'optocoupleur (OK) est relié du côté secondaire d'une part à la base du transistor à bascule (T₂) et d'autre part de préférence à une prise du diviseur de tension entre deux résistances individuelles (R_{G2}, R_{B} ou R_{G21}, R_{G22}) du circuit résistant série (R_{G}).

10. Alimentation à découpage selon l'une des revendications 7 à 9,
**caractérisée par le fait que** la base du transistor à bascule (T₂) est reliée d'une part, via un circuit RC série (R_{T} ; C_{T}), au drain (D) de l'élément de commutation (T₁) et d'autre part - en particulier via une résistance série (R_{V}) - à un point de commutation entre la résistance de commande (R_{M}) et la source (S) de l'élément de commutation (T₁).

11. Alimentation à découpage selon l'une des revendications 7 à 10,
**caractérisée par le fait que** le transistor à bascule (T₂) est branché par sa ligne collecteur-émetteur entre d'une part la grille (G) de l'élément de commutation (T₁), en particulier une prise du diviseur de tension entre deux résistances individuelles (R_{B} et R_{G2} ou R_{G22}), et d'autre part une ligne négative (-).

12. Alimentation à découpage selon l'une des revendications 7 à 11,
**caractérisée par le fait qu'**une diode Zener (D₂) est branchée en parallèle avec la ligne collecteur-émetteur du transistor à bascule (T₂).

13. Alimentation à découpage selon l'une des revendications 10 à 12,
**caractérisée par le fait que** le circuit RC série (R_{T} ; C_{T}) présente une résistance formée comme un diviseur de tension composé de deux sous-résistances (R_{T1} ; R_{T2}), sa prise médiane étant reliée par une diode de protection (D_{S}) à la ligne négative (-).
